(19) Europäisches Patentamt
European Patent Office
Office européen des brevets

(11) **EP 4 711 182 A1**

(12) **EUROPEAN PATENT APPLICATION**

(43) Date of publication:
18.03.2026 Bulletin 2026/12

(21) Application number: 25201652.2

(22) Date of filing: 11.09.2025

(51) International Patent Classification (IPC):
*B60L 3/04* (2006.01)   *B60L 3/12* (2006.01)
*B60L 53/14* (2019.01)   *B60L 53/20* (2019.01)
*B60L 53/62* (2019.01)   *H02J 7/02* (2016.01)
*G01R 23/00* (2006.01)   *H02H 11/00* (2006.01)
*H02M 1/32* (2007.01)

(52) Cooperative Patent Classification (CPC):
B60L 3/04; B60L 3/12; B60L 53/14; B60L 53/20;
B60L 53/62; G01R 23/00; H02H 11/006; H02J 7/02;
H02M 1/32; B60L 2210/30; B60L 2240/526

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 12.09.2024   KR 20240124905
19.09.2024   KR 20240126441

(71) Applicant: LG INNOTEK CO. LTD
Gangseo-gu
Seoul 07796 (KR)

(72) Inventors:
• PARK, Heo Kyoung
07796 Seoul (KR)
• KIM, Dong Jin
07796 Seoul (KR)
• HAN, Chang Dae
07796 Seoul (KR)
• CHAE, Hyung Jun
07796 Seoul (KR)
• KIM, Seung Hyun
07796 Seoul (KR)

(74) Representative: M. Zardi & Co S.A.
Via G. B. Pioda, 6
6900 Lugano (CH)

(54) **VEHICLE CHARGING DEVICE**

(57) A vehicle charging device according to the present embodiment comprises: an amplitude detection unit that detects a magnitude of a grid voltage being inputted to the vehicle charging device; a frequency detection unit that detects a frequency of the grid voltage; a PLL (Phase Locked Loop) unit that monitors a phase of the grid voltage; and a gain selection unit that inputs a coefficient calculated using the magnitude and frequency of the grid voltage to the PLL unit, wherein the amplitude detection unit and the frequency detection unit detect a plurality of points at which the state of the grid voltage changes.

FIG. 1

**Description**

[Technical Field]

The present embodiment relates to a vehicle charging device.

[Background Art]

As environmental problems caused by exhaust fumes from internal combustion engine vehicles become more serious, production of eco-friendly electric vehicles is increasing, and recently, major automobile producing countries have announced that they will gradually change all automobiles to eco-friendly vehicles, and many countries are reducing the production of internal combustion engine vehicles and increasing the production and sales of eco-friendly vehicles such as electric vehicles.

An electric vehicle (EV) is an automobile primarily driven by a motor powered by a battery. A charger is needed to charge the battery, and since charging occurs repeatedly through the charger, the charger plays a crucial role in the electric vehicle.

As the charger is operated without checking for aging of the internal components of the electric vehicle charger, shrinkage and expansion due to temperature changes over the four seasons, and faulty fastening due to micro-vibrations, a high voltage arc is applied to the electric vehicle battery due to a defect during operation, or the charger stops operating due to a defect in the charger. This, in turn, directly leads to societal losses.

[Detailed Description of the Invention]

[Technical Subject]

The present embodiment is intended to provide a vehicle charging device having improved phase tracking performance and a vehicle charging device capable of preventing circuit damage and malfunction.

[Technical Solution]

A vehicle charging device according to the present embodiment comprises: an amplitude detection unit that detects a magnitude of a grid voltage being inputted to the vehicle charging device; a frequency detection unit that detects a frequency of the grid voltage; a PLL (Phase Locked Loop) unit that monitors a phase of the grid voltage; and a gain selection unit that inputs a coefficient calculated using the magnitude and frequency of the grid voltage to the PLL unit, wherein the amplitude detection unit and the frequency detection unit detect a plurality of points at which the state of the grid voltage changes.

The plurality of points at which the state of the grid voltage changes are points at which the grid voltage changes from an increasing direction to a decreasing direction or from a decreasing direction to an increasing direction, and the amplitude detection unit can detect the amplitude of the grid voltage through an average of the voltages of the plurality of points.

The plurality of points at which the state of the grid voltage changes are points at which the grid voltage changes from an increasing direction to a decreasing direction or from a decreasing direction to an increasing direction, and the frequency detection unit can detect the frequency of the grid voltage through an average of the cycles of the plurality of points.

The PLL unit comprises: a phase detection unit for detecting an error between the phase of the grid voltage and the phase of the voltage outputted from the PLL unit; an LPF (Low Pass Filter) unit for removing noise from a signal output from the phase detection unit; and a VCO (Voltage Controlled Oscillator) unit for adjusting the voltage frequency of the signal outputted from the LPF unit, wherein the gain selection unit can input the coefficient to the LPF unit and the VCO unit.

The LPF unit comprises a notch filter and an integrator, and the gain selection unit can input the coefficient to the notch filter and the integrator.

A vehicle charging method according to the present embodiment comprises steps of: detecting a plurality of points at which a state of a grid voltage changes; detecting a magnitude and a frequency of the grid voltage through the plurality of points; and inputting a coefficient calculated using the magnitude and frequency of the grid voltage into a PLL unit.

The plurality of points at which the state of the above grid voltage changes are points at which the grid voltage changes from an increasing direction to a decreasing direction or from a decreasing direction to an increasing direction, the magnitude of the grid voltage can be detected through an average of the voltages of the plurality of points, and the frequency of the grid voltage can be detected through an average of the cycles of the plurality of points.

The PLL unit comprises: a phase detection unit for detecting an error between the phase of the grid voltage and the phase of the voltage outputted from the PLL unit; an LPF (Low Pass Filter) unit for removing noise from a signal outputted from the phase detection unit; and a VCO (Voltage Controlled Oscillator) unit for adjusting the voltage frequency of a signal outputted from the LPF, wherein the step of inputting a coefficient calculated using the amplitude and frequency of the grid voltage into the PLL unit can input the coefficient into the LPF unit and the VCO unit.

According to another embodiment of the present invention, a vehicle charging device comprises: an amplitude detection unit for detecting a magnitude of a grid voltage being inputted to the vehicle charging device; a frequency detection unit for detecting a frequency of the grid voltage; and a control unit for setting a plurality of normal operating ranges for the magnitude or frequency of the grid voltage and determining whether each of the magnitude or frequency of the grid voltage is within a normal operating range, wherein the amplitude detection unit and the frequency detection unit detect a plurality of points at which the state of the grid voltage changes.

The plurality of points at which the state of the grid voltage changes include points at which the magnitude of the grid voltage changes from an increasing direction to a decreasing direction or points at which the magnitude of the grid voltage changes from a decreasing direction to an increasing direction, and the amplitude detection unit can detect the magnitude of the grid voltage through an average of the voltages of the plurality of points.

The plurality of points at which the state of the grid voltage changes include points at which the magnitude of the grid voltage changes from an increasing direction to a decreasing direction or from a decreasing direction to an increasing direction, and the frequency detection unit can detect the frequency of the grid voltage through an average of the cycles of the plurality of points.

The normal operating range of the magnitude of the grid voltage may include a plurality of first ranges not being overlapped with one another, and the normal operating range of the frequency of the grid voltage may include a plurality of second ranges not being overlapped with one another.

The amplitude detection unit detects the maximum and minimum values of the magnitude of the grid voltage during a preset time, the frequency detection unit detects the maximum and minimum values of the frequency of the grid voltage during the preset time, and the control unit can determine which range of the plurality of first ranges the magnitude of the grid voltage falls into and which range of the plurality of second ranges the frequency of the grid voltage falls into.

The control unit may perform vehicle charging when the magnitude of the grid voltage corresponds to at least one among the plurality of first ranges and when the frequency of the grid voltage corresponds to at least one among the plurality of second ranges.

The control unit can identify which range among the plurality of first ranges the magnitude of the grid voltage falls into and select a voltage level for overvoltage protection (OVP) or a voltage level for under voltage protection (UVP).

A vehicle charging method according to another embodiment of the present invention comprises steps of: detecting a plurality of points at which the state of the grid voltage changes; detecting the magnitude and frequency of the grid voltage through the plurality of points; and determining whether the magnitude or frequency of the grid voltage is within a normal operating range, respectively.

The plurality of points at which the state of the grid voltage changes are points at which the magnitude of the grid voltage changes from an increasing direction to a decreasing direction or from a decreasing direction to an increasing direction, and the magnitude of the grid voltage can be detected through an average of the voltages of the plurality of points, and the frequency of the grid voltage can be detected through an average of the cycles of the plurality of points.

The step of detecting the magnitude and frequency of the grid voltage through the plurality of points includes detecting a maximum and a minimum value of the magnitude of the grid voltage during a preset time period, and detecting the maximum and the minimum value of the frequency of the grid voltage during the preset time period; and the step of determining whether the magnitude or the frequency of the grid voltage is within a normal operating range, respectively, includes confirming which of a plurality of first ranges the magnitude of the grid voltage is within, and confirming which of a plurality of second ranges the frequency of the grid voltage is within, wherein the plurality of first ranges is normal operating ranges of the magnitude of the grid voltage not being overlapped with one another, and the plurality of second ranges may be normal operating ranges of the frequency of the grid voltage not being overlapped with one another.

[Advantageous Effects]

According to the present embodiment, a gain value optimized for the grid voltage can be adjusted to secure faster tracking performance in grid phase tracking.

In addition, even if the system phase changes due to an accident or grid conditions, the performance can be improved by improving the power factor and preventing reverse current with fast tracking performance.

In addition, the voltage level for OVP (Over Voltage Protection) and UVP (Under Voltage Protection) can be selected by pre-determining the grid voltage being inputted to the vehicle charging device, and the frequency level for OFP (Over Frequency Protection) and UFP (Under Frequency Protection) can be selected. Through this, circuit damage and malfunction in the vehicle charging device can be prevented.

[Brief Description of Drawings]

FIG. 1 is a block diagram of a vehicle charging device according to the present embodiment.

FIG. 2 is a diagram for explaining an operation of detecting the amplitude and frequency of a grid voltage of a vehicle charging device according to the present embodiment.

FIG. 3 is a table for explaining a coefficient calculated using the amplitude and frequency of a vehicle charging device according to the present embodiment.

FIG. 4 is a flow chart of a vehicle charging method according to the present embodiment.

FIGS. 5 to 8 are diagrams for explaining an improvement effect on disturbance of a vehicle charging device according to the present embodiment.

FIG. 9 is a diagram for comparing and explaining the effects of a conventional vehicle charging device and a vehicle charging device according to the present embodiment.

FIG. 10 is a block diagram of a vehicle charging device according to another embodiment of the present invention.

FIG. 11 is a flow chart of a vehicle charging method according to another embodiment of the present invention.

FIG. 12 is a diagram for explaining the range of a grid voltage of a vehicle charging device according to another embodiment of the present invention.

FIG. 13 is a diagram for explaining the frequency range of a grid voltage of a vehicle charging device according to another embodiment of the present invention.

[BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention. In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used.

These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

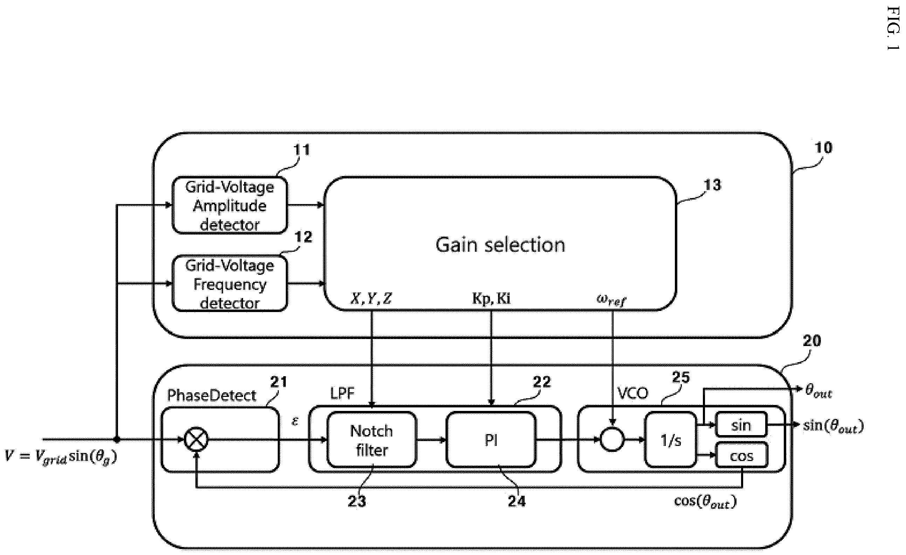

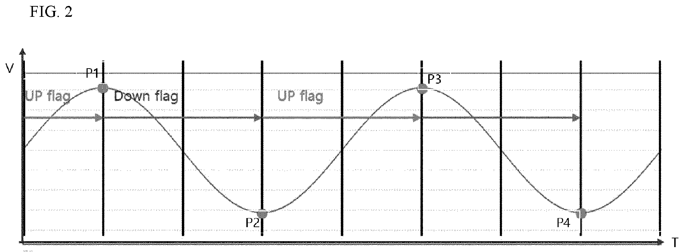

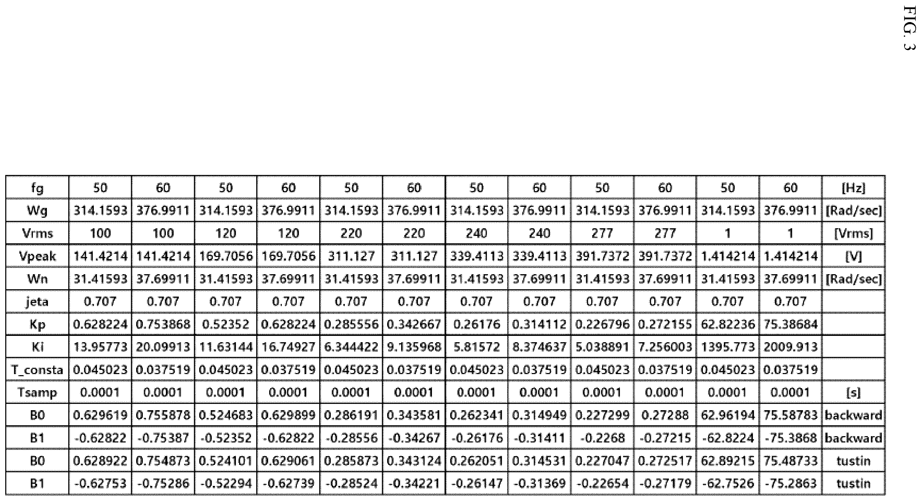

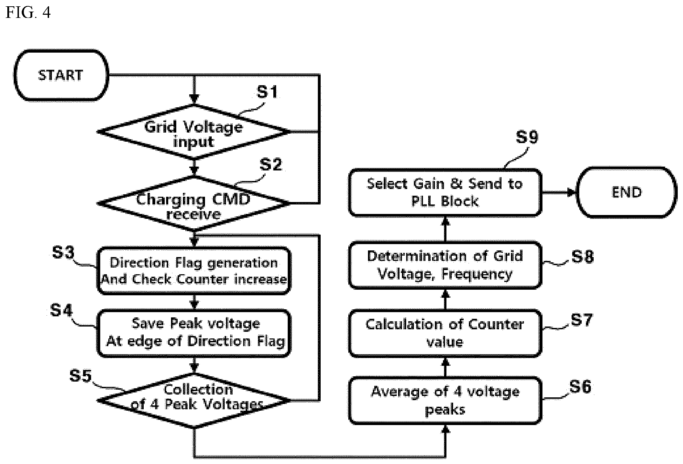

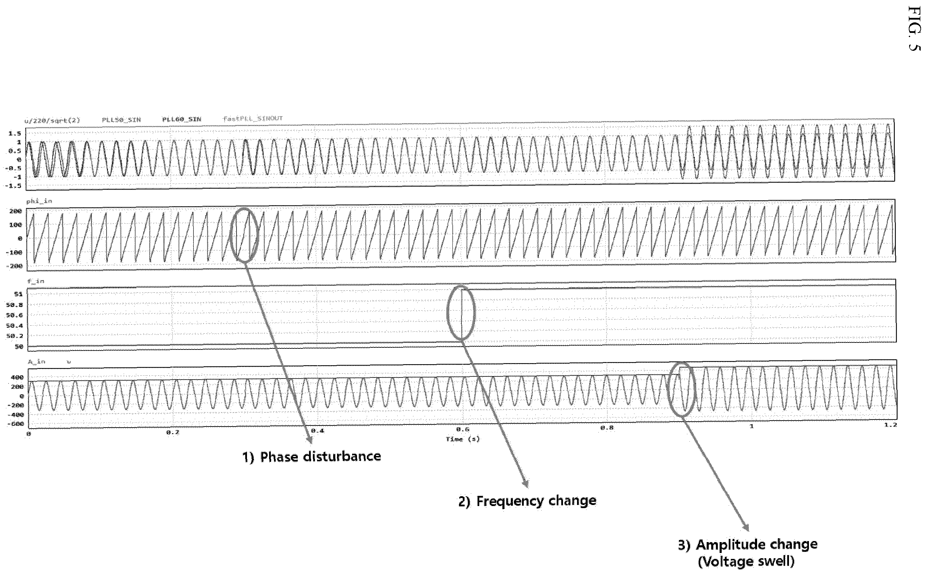

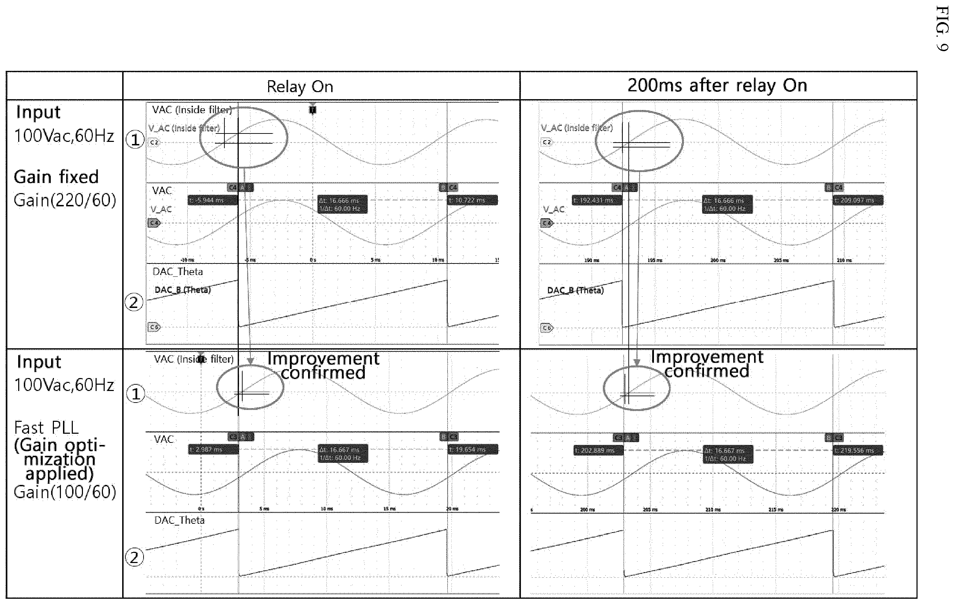

FIG. 1 is a block diagram of a vehicle charging device according to the present embodiment; FIG. 2 is a diagram for explaining an operation of detecting the amplitude and frequency of a grid voltage of a vehicle charging device according to the present embodiment; FIG. 3 is a table for explaining a coefficient calculated using the amplitude and frequency of a vehicle charging device according to the present embodiment; FIG. 4 is a flow chart of a vehicle charging method according to the present embodiment; FIGS. 5 to 8 are diagrams for explaining an improvement effect on disturbance of a vehicle charging device according to the present embodiment; and FIG. 9 is a diagram for comparing and explaining the effects of a conventional vehicle charging device and a vehicle charging device according to the present embodiment.

The vehicle charging device according to the present embodiment may be an OBC (On Board Charger) that charges a battery using power from an AC power source when connected to an AC power source. The AC power being inputted to the on-board charger has various grid voltage amplitudes and frequencies depending on the country, and the on-board charger has been designed to operate with a fixed PLL tuning coefficient even if the frequency or voltage magnitude changes. This causes problems in that, when there is a sag (a phenomenon in which voltage temporarily decreases) or swell (a phenomenon in which voltage temporarily increases) of the grid voltage and a phase change or a frequency change, an error in phase tracking occurs and a reverse inrush current occurs. In addition, there is a problem in that the PF (Power Factor) and THD (Total Harmonic Distortion), which are key performance indicators of the on-board charger performance, are adversely affected and product damage occurs.

The configuration included in a vehicle charging device of the present embodiment described below can be applied to all power conversion devices connected to the grid voltage. For example, the power conversion devices can include EVSE, server power, ESS, inverters, and converters, and the like.

The vehicle charging device according to the present embodiment may include a monitoring unit **10** and a PLL unit **20**. The monitoring unit **10** may include an amplitude detection unit **11**, a frequency detection unit **12**, and a gain selection unit **13**. According to another embodiment, the vehicle charging device may not include a separate monitoring unit **10**, but may include an amplitude detection unit **11**, a frequency detection unit **12**, and a gain selection unit **13** as individual configurations. The PLL unit **20** may include a phase detection unit **21**, an LPF unit **22**, and a VCO unit **25**.

The amplitude detection unit **11** can detect the magnitude of the grid voltage being inputted to the vehicle charging device. The magnitude of the grid voltage may mean the amplitude of the voltage. The amplitude of the voltage is a term that represents the maximum fluctuation range of an electric signal, and in AC voltage, the amplitude can be defined as the distance from the reference line (O V) to the maximum or minimum value of the voltage waveform. The magnitude or amplitude of the grid voltage ($V = V_{grid}\sin(\theta_g)$) described below may mean $V_{grid}$.

The frequency detection unit **12** can detect the frequency of the grid voltage being inputted to the vehicle charging device. The frequency of the voltage is a term that indicates how many times the voltage waveform is repeated over a certain period of time. When the time required for one cycle in the voltage waveform is called a period, the frequency of the voltage may be defined as the reciprocal of the period.

The amplitude detection unit **11** and the frequency detection unit **12** can detect multiple points at which the grid voltage state changes. The multiple points at which the grid voltage state changes may be points at which the grid voltage changes from an increasing direction (Up flag) to a decreasing direction (Down flag) or points at which the grid voltage changes from a decreasing direction to an increasing direction. The amplitude detection unit **11** can detect the magnitude of the grid voltage through an average of the voltages of multiple points at which the grid voltage state changes. The frequency detection unit **12** can detect the frequency of the grid voltage through an average of the cycles of multiple points at which the state of the grid voltage changes.

Referring to FIG. 2, points **P1** and **P3** where the state of the grid voltage changes from an increasing direction to a decreasing direction and points **P2** and **P4** where the state changes from a decreasing direction to an increasing direction can be detected. At this time, the amplitude detection unit **11** can detect the magnitude of the grid voltage by calculating the average of the voltages of **P1** to **P4**, and the frequency detection unit **12** can calculate the period of the waveform of the grid voltage by calculating the time required from **P1** to **P3** and the time required from **P2** to **P4**, and can detect the frequency of the grid voltage by converting it into a reciprocal number.

The gain selection unit **13** can input the coefficient calculated using the magnitude and frequency of the grid voltage to the PLL unit **20**. The gain selection unit **13** can input the calculated coefficient to the LPF unit **22** and the VCO unit **25** of the PLL unit **20**. The gain selection unit **13** can input the calculated coefficient to each of the notch filter **23** and the integrator **24** of the LPF unit **22**. The operation of calculating the coefficient using the magnitude and frequency of the grid voltage in the gain selection unit **13** will be described in detail after the description of each component included in the PLL unit **20**.

The PLL (Phase Locked Loop) unit **20** can monitor the phase of the grid voltage. The PLL unit **20** is an electronic circuit used to synchronize the frequency and phase of the grid voltage, and the PLL unit **20** may comprise a phase detection unit **21**, an LPF unit **22**, and a VCO unit **25**.

The phase detection PD unit **21** can detect the phase error ($\varepsilon$) between the phase of the grid voltage and the phase of the voltage outputted from the PLL unit **20**. The phase detection unit **21** can convert the phase error ($\varepsilon$) into a voltage signal.

The LPF unit (Loop Filter) **22** can remove noise from the signal outputted from the phase detection unit **21**. The LPF unit **22** can maintain an appropriate bandwidth, and the signal outputted from the LPF unit **22** can be used as a control signal of the VCO unit **25**. The LPF unit **22** may include a notch filter **23** and an integrator **24**. The notch filter **23** is a filter that selectively attenuates a specific frequency band and is mainly used to reduce frequency interference. The notch filter **23** can improve the quality of the output signal by removing interference or vibration at a specific frequency. The integrator **24** can generate a voltage signal by accumulating a phase error ($\varepsilon$) over time.

The VCO (Voltage Controlled Oscillator), unit **25** can adjust the frequency of the voltage of the signal outputted from the LPF unit **22**. The VCO unit **25** can output a sine wave ($\sin(\theta_{out})$) and a grid angle ($\theta_{out}$). The grid angle ($\theta_{out}$) is an angle that represents how much the frequency signal has shifted for a specific time, and when the PLL unit **20** is stabilized, the difference between the grid voltage input to the PLL unit **20** and the grid angle ($\theta_{out}$) of the output signal of the VCO unit **25** may become very small. The signal outputted from the VCO unit **25** can be fed back to the phase detection unit **21**. The VCO unit **25** can feed back a sine wave ($\sin(\theta_{out})$) and a cosine wave ($\cos(\theta_{out})$) having a phase difference of 90 degrees to the phase detection unit **21**.

Hereinafter, the operation of each component of the PLL unit **20** and the process being applied with the coefficients calculated in the gain selection unit **13** are described.

Assuming that a sine wave ($\sin(\theta_{out})$) close to the grid voltage ($V = V_{grid} \sin(\theta_g)$) is outputted from the VCO unit **25**, the VCO unit **25** feeds back a cosine wave ($V' = \cos(\theta_{out})$) with a 90 degree phase difference to the phase detection unit **21**. The phase detection unit **21** detects the phase error ($\varepsilon$) by multiplying the grid voltage ($V = V_{grid} \sin(\theta_g)$) and the cosine wave ($V' = \cos(\theta_{out})$).

$$(1) \quad V = V_{grid}\sin(\theta_g) = V_{grid}\sin\left(\omega_{g \cdot t} + \theta_{grid}\right)$$

$$(2) \quad V' = \cos(\theta_{out}) = \cos(\omega_{PLL \cdot t} + \theta_{PLL})$$

$$(3) \quad \varepsilon = \cos(\omega_{PLL \cdot t} + \theta_{PLL}) * V_{grid}\sin\left(\omega_{g \cdot t} + \theta_{grid}\right)$$

When the phase error ($\varepsilon$) in the above mathematical equation (3) is linearized, it can be expressed as the mathematical equation (4) below.

$$(4) \quad \varepsilon = \frac{V_{grid}(\theta_{grid} - \theta_{PLL})}{2}$$

A notch filter **23** is a filter that selectively attenuates a specific frequency band, and the transfer function of the notch filter **23** can be as shown in the mathematical expression (5) below.

$$(5) \quad H\_notch(s) = \frac{s^2 + 2\zeta_z\omega_g s + \omega_g^2}{s^2 + 2\zeta_p\omega_g s + \omega_g^2}$$

$\zeta_p$: Depth of notch filter, $\zeta_z$: Width of notch filter, $\omega_g$: Grid frequency(Cut-off frequency)

If the above mathematical expression (5) is converted from the s-domain transfer function to the z-domain transfer function using the Tustin transform, it can be as shown in the mathematical expression (6) below.

$$(6) \quad H(s) = \frac{b_0 + b_1 z^{-1} + b_2 z^{-2}}{a_0 + a_1 z^{-1} + a_2 z^{-2}}$$

Here, the coefficient of mathematical expression (6) can be organized as mathematical expressions (7) and (8) below. The coefficients X, Y, and Z of mathematical expression (8) can be calculated through the magnitude and frequency of the grid voltage in the gain selection unit (13).

$$(7)$$

$$a_0 = 1, \ a_1 = X - 2, a_2 = -X + Z + 1, \ b_0 = 1, b_1 = Y - 2, b_2 = -Y + Z + 1$$

$$(8) \quad X = 2*c2*wg*2*Tsamp, \ Y = 2*c1*wg*2*Tsamp, \ Z = (2*wg*Tsamp)^2$$

In the above equation (8), Tsamp may be a control sampling time of the vehicle charging device. For example, the vehicle charging device may monitor the grid voltage every 10 kHz, and the sampling time may be 1/10000 sec. c1 may be a constant for the attenuation degree, and c2 may be a constant for the bandwidth.

Afterwards, when the signal outputted from the notch filter **23** is inputted to the integrator **24**, the phase error ($\varepsilon$)

can be accumulated over time to generate a voltage signal. The transfer function of the integrator **24** can be as shown in the mathematical expression (9) below.

$$(9) \quad H_{PI(s)} = K_p + \frac{K_I}{s} \left( K_p : proportional\ gain,\ K_I : intergration\ gain \right)$$

When the above mathematical expression (9) is converted from an s-domain transfer function to a z-domain transfer function using the Tustin transform, it can be transformed as in the mathematical expression (10) below.

$$(10) \quad H_{PI}(s) = \frac{B0 + B1z^{-1}}{1 - z^{-1}}$$

If mathematical expression (10) is expressed as a discrete equation for digital operation, it can be as mathematical expression (11).

$$(11) \quad Y(k) = B_0 U_{(k)} + B_1 U_{(k-1)} + Y_{(k-1)}$$

Here, the coefficient of mathematical expression (9) can be organized as mathematical expression (12) below. The coefficient of mathematical expression (12) can be calculated through the magnitude and frequency of the grid voltage in the gain selection unit **13**.

$$(12) \quad K_p = \frac{4\zeta\omega_n}{A_o},\ K_I = \frac{2\omega_n^2}{A_o},\ \zeta = 0.707,\ \omega_n = 0.1\omega_g,\ \omega_g = rated\ frequency$$

Thereafter, the VCO unit **25** can adjust the voltage frequency of the signal outputted from the LPF unit **22**, and the VCO unit **25** can tune the voltage inputted to the VCO unit **25** for a specific frequency $\omega_{ref}$ range. At this time, the required coefficient $\omega_{ref}$ can be calculated through the frequency of the grid voltage $\omega_g$ in the gain selection unit **13**. According to another embodiment, the reference frequency $\omega_{ref}$ for tuning in the VCO unit **25** may be the frequency of the grid voltage $\omega_g$ detected by the frequency detection unit **12**.

As described above, the coefficients being inputted to the LPF unit **22** and VCO unit **25** of the PLL unit **20** can be pre-calculated through the magnitude and frequency of the grid voltage in the gain selection unit **13** and stored in the form of a lookup table as shown in FIG. 3. That is, when the magnitude and frequency of the grid voltage are detected in the amplitude detection unit **11** and frequency detection unit **12** of the monitoring unit **10**, the gain selection unit **13** can input the coefficients matching the magnitude and frequency of the grid voltage to the PLL unit **20**.

Hereinafter, with reference to FIG. 4, each step of the vehicle charging method according to the present embodiment will be described. Since the vehicle charging method according to the present embodiment overlaps with the description of the vehicle charging device described above, a detailed description will be omitted. In addition, the vehicle charging method according to the present embodiment does not need to include all of the steps described below, and some may be omitted, and it is natural that some steps may be expressed as combined steps.

In the vehicle charging method according to the present embodiment, a grid voltage is inputted to a vehicle charging device **S1**, and a charging start command (CMD) can be received **S2**. Thereafter, the directionality (Flag) of the grid voltage is confirmed to check the point at which the state of the grid voltage changes **S3**, the peak voltage is stored at the point (Edge) at which the directionality of the grid voltage changes **S4**, and four peak voltages are collected **S5**. Thereafter, the average of the four peak voltages is calculated **S6**, the frequency is calculated through the cycle of the four peak voltages **S7**, and the magnitude and frequency of the grid voltage are determined **S8**. Then, the coefficient (or gain) calculated through the magnitude and frequency of the grid voltage is inputted to the PLL unit **S9**.

Hereinafter, the improvement effects according to the vehicle charging device and vehicle charging method according to the present embodiment will be described with reference to FIGS. 5 to 9.

Referring to FIG. 5, the grid voltage may experience unstable conditions such as (1) phase change or distortion, (2) frequency change, and (3) amplitude change. When such grid voltage fluctuations occur, the vehicle charging device must follow the phase more quickly to supply power stably.

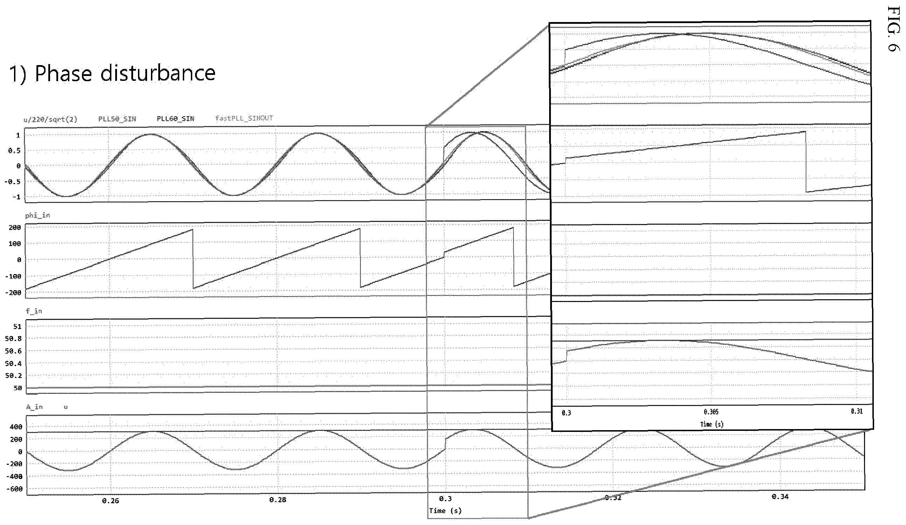

In the top graphs illustrated in FIGS. 6 to 8, the waveform of the grid voltage (u/220/sqrt2) is indicated by a green line, the waveform of the output voltage of the PLL (PLL50_SIN) when the PLL operates at a fixed frequency of 50 Hz being applied to the PLL is indicated by a red line, the waveform of the output voltage of the PLL (PLL60_SIN) when the PLL operates at a fixed frequency of 60 Hz being applied to the PLL is indicated by a blue line, and the waveform of the voltage (fastPLL_SINOUT) outputted by applying a coefficient calculated through the magnitude and frequency of the grid voltage in the PLL unit of the vehicle charging device according to the present embodiment is indicated by a yellow line.

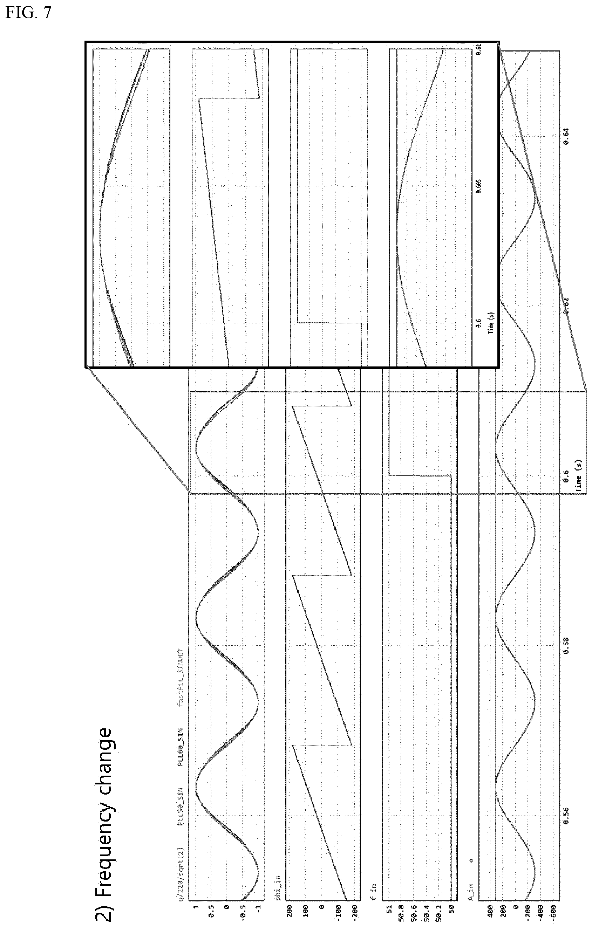

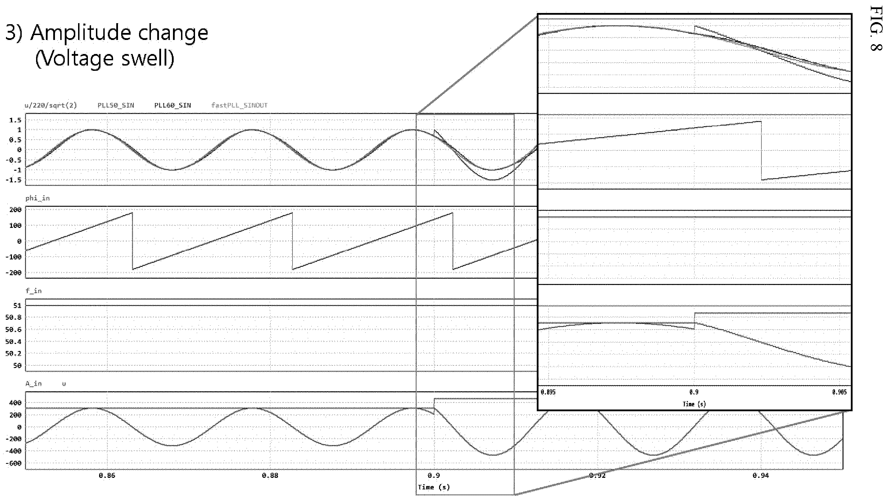

FIG. 6 shows a case where a phase change or distortion of the grid voltage occurs, and it can be confirmed that the yellow line follows the green line faster than the red and blue lines. FIG. 7 shows a case where a frequency change of the grid voltage occurs, and it can be confirmed that the yellow line follows the green line faster than the red and blue lines. FIG. 8 shows a case where an amplitude change of the grid voltage occurs, and it can be confirmed that the yellow line follows the green line faster than the red and blue lines. That is, the vehicle charging device and the vehicle charging method according to the present embodiment can secure faster phase tracking performance by detecting the magnitude and frequency of the grid voltage in real time, and calculating and applying the coefficient applied to the PLL unit through the same.

The upper graph in FIG. 9 shows the waveform of the voltage being outputted when the grid voltage is inputted as 100 Vac, 60 Hz and is fixed to 220 Vac, 60 Hz during PLL operation, and the lower graph shows the waveform of the voltage being outputted from the PLL when the coefficient optimized for the magnitude and frequency of the grid voltage is inputted to the PLL according to the present embodiment when the grid voltage is inputted as 100 Vac, 60 Hz. When comparing the part where each voltage waveform zero-crosses in the area where the theta value is 0 degrees, it can be confirmed that there is an improved phase tracking effect through the reduction in the error (gap) of the lower graph compared to the upper graph.

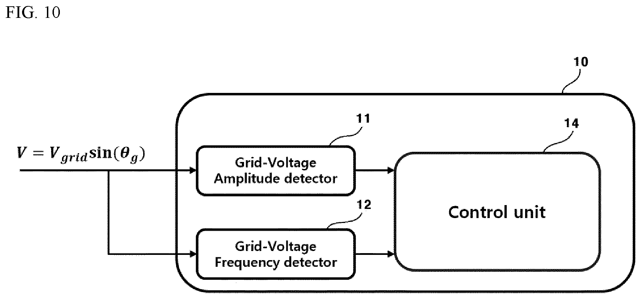

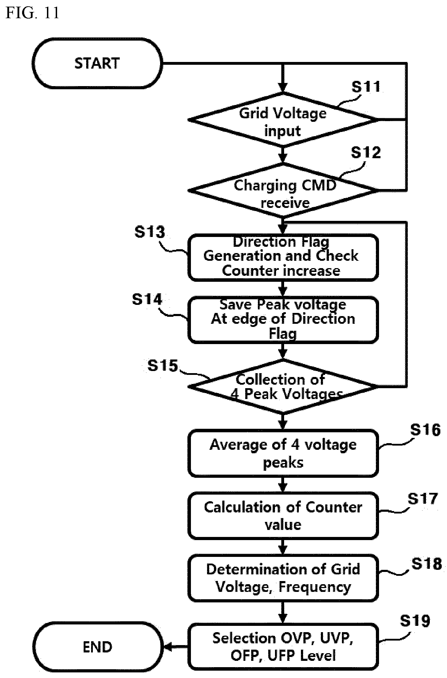

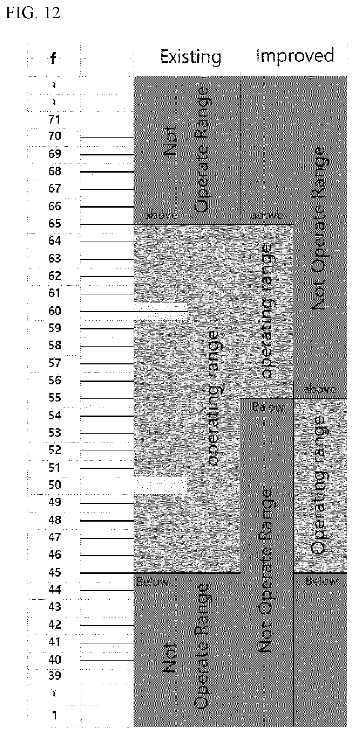

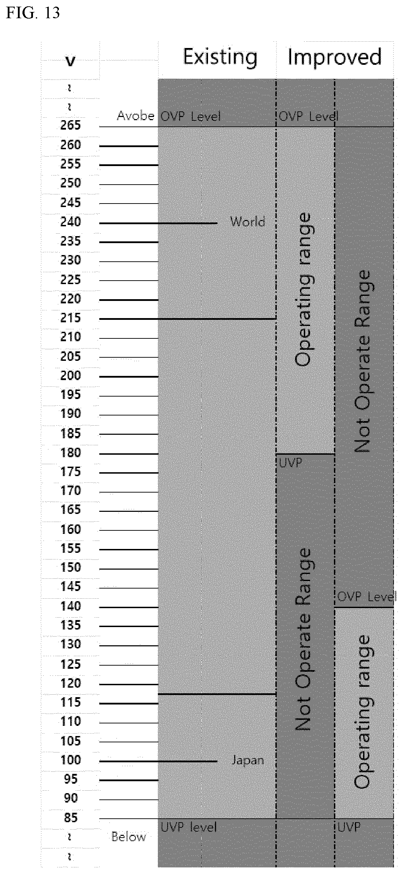

FIG. 10 is a block diagram of a vehicle charging device according to another embodiment of the present invention; FIG. 11 is a flowchart of a vehicle charging method according to another embodiment of the present invention; FIG. 12 is a diagram for explaining a range of grid voltage of a vehicle charging device according to another embodiment of the present invention; and FIG. 13 is a diagram for explaining a frequency range of grid voltage of a vehicle charging device according to another embodiment of the present invention.

According to another embodiment of the present invention, a vehicle charging device may be an on-board charger (OBC) that charges a battery using power from an AC power source when connected to an AC power source. The AC power being inputted to the on-board charger has various grid voltage amplitudes and frequencies depending on the country, and the on-board charger has been designed to operate regardless of the frequency or voltage. This is because, considering grid voltage sags (a phenomenon in which voltage temporarily decreases) or swells (a phenomenon in which voltage temporarily increases), the on-board charger continues to operate even when the grid voltage goes out of its allowable range, which may cause damage to the circuit.

A vehicle charging device according to another embodiment of the present invention includes a monitoring unit 10, and the monitoring unit 10 may include an amplitude detection unit 11, a frequency detection unit 12, and a control unit 14. According to another embodiment, the vehicle charging device may not include a separate monitoring unit 10, but may include an amplitude detection unit 11, a frequency detection unit 12, and a control unit 14 as individual configurations. The amplitude detection unit 11 and the frequency detection unit 12 according to another embodiment of the present invention overlap with the contents described with reference to FIGS. 1 and 2, and therefore are omitted.

The control unit 14 can set multiple normal operation ranges for the magnitude or frequency of the grid voltage, and determine whether the magnitude or frequency of the grid voltage is within the normal operation range. If the control unit 14 determines that the magnitude or frequency of the grid voltage is not within the normal operation range, the control unit 14 can block the input of the grid voltage or stop the operation of the vehicle charging device. The control unit 14 may be referred to as an operation level setting unit.

The normal operating range of the magnitude of the grid voltage may include a plurality of first ranges not being overlapped with one another. Referring to FIG. 12, while the existing allowable range of the grid voltage is 85 V to 265 V, the normal operating range of the magnitude of the grid voltage in the vehicle charging device according to the present embodiment may be subdivided by country or charging standard. For example, the plurality of first ranges may include a range of 85 V to 140 V and a range of 180 V to 265 V. The control unit 14 may control the vehicle charging device to operate in only one of the plurality of first ranges. The control unit 14 may control the vehicle charging device to operate in all of the plurality of first ranges.

The normal operating range of the frequency of the grid voltage may include a plurality of second ranges that not being overlapped with one another. Referring to FIG. 13, while the allowable range of the frequency of the existing grid voltage is 45 Hz to 65 Hz, the normal operating range of the frequency of the grid voltage in the vehicle charging device according to the present embodiment may be subdivided according to each country or charging standard. For example, the plurality of second ranges may include a range of 45 Hz to 55 Hz and a range of 55 Hz to 65 Hz. The control unit 14 may control the vehicle charging device to operate in only one of the plurality of second ranges. The control unit 14 may control the vehicle charging device to operate in all of the plurality of second ranges.

The control unit 14 can perform vehicle charging when the magnitude of the grid voltage corresponds to at least one of a plurality of first ranges and when the frequency of the grid voltage corresponds to at least one of a plurality of second ranges.

The amplitude detection unit 11 can detect the maximum and minimum values of the grid voltage during a preset time. Here, the preset time may be a certain time before the start of charging of the vehicle charging device, a certain time after the start of charging of the vehicle charging device, or a certain time after a certain amount of charge is reached during charging. According to another embodiment, the amplitude detection unit **11** can detect by monitoring the magnitude of the grid voltage during vehicle charging and updating the maximum and minimum values. This is merely an example and is not particularly limited thereto.

The control unit **14** may check which range among the plurality of first ranges the magnitude of the grid voltage falls within. The control unit **14** may select a voltage level for overvoltage protection (OVP) or a voltage level for under voltage protection (UVP) by checking which range among the plurality of first ranges the magnitude of the grid voltage falls within. Through this, when it is determined that the grid voltage being inputted to the vehicle charging device is outside the OVP or UVP, the input of the grid voltage can be blocked or the operation of the vehicle charging device can be stopped.

The frequency detection unit **12** can detect the maximum and minimum values of the frequency of the grid voltage during a preset time. The control unit **14** can check which range of the frequency of the grid voltage is among a plurality of second ranges. Here, the preset time may be a certain time before the start of charging of the vehicle charging device, a certain time after the start of charging of the vehicle charging device, or a certain time after a certain amount of charge is reached during charging. According to another embodiment, the frequency detection unit **12** can detect by monitoring the frequency of the grid voltage during vehicle charging and updating the maximum and minimum values. This is merely an example and is not particularly limited thereto.

The control unit **14** can check which range among the plurality of second ranges the magnitude of the grid voltage falls within. The control unit **14** can select a frequency level for over-frequency protection (OFP) or under-frequency protection (UFP) by checking which range among the plurality of second ranges the magnitude of the grid voltage falls within. Through this, when it is determined that the grid voltage being inputted to the vehicle charging device is outside the OFP or UFP, the input of the grid voltage can be blocked or the operation of the vehicle charging device can be stopped.

Hereinafter, with reference to FIG. 11, each step of the vehicle charging method according to the present embodiment will be described. Since the vehicle charging method according to the present embodiment overlaps with the description of the vehicle charging device described above, a detailed description will be omitted. In addition, the vehicle charging method according to the present embodiment does not need to include all of the steps described hereinafter, and some may be omitted, and it is natural that some steps may be expressed as combined steps.

In the vehicle charging method according to the present embodiment, a grid voltage is inputted to a vehicle charging device **S11**, and a charging start command (CMD) can be received **S12**. Thereafter, the directionality (Flag) of the grid voltage is confirmed to check the point at which the state of the grid voltage changes **S13**, the peak voltage is stored at the point (Edge) at which the directionality of the grid voltage changes **S14**, and four peak voltages are collected **S15**. Thereafter, the average of the four peak voltages is calculated **S16**, the frequency is calculated through the cycle of the four peak voltages **S17**, and the magnitude and frequency of the grid voltage are determined **S18**. Then, the range of levels of OVP, UVP, OFP, and UFP is selected to prevent circuit damage and ensure safe operation of the vehicle charging device **S19**.

The modification according to the present embodiment may include some of the components of the embodiment described with reference to FIGS. 1 to 9 together with some of the components of the embodiment described with reference to FIGS. 10 to 13. That is, the modification may include the embodiment described with reference to FIGS. 1 to 9, but with certain components of the embodiment described with reference to FIGS. 1 to 9 omitted and corresponding components of the embodiment described with reference to FIGS. 10 to 13 included. Alternatively, the modification may include the embodiment described with reference to FIGS. 10 to 13, but with certain components of the embodiment described with reference to FIGS. 10 to 13 omitted and corresponding components of the embodiment described with reference to FIGS. 1 to 9 included.

The features, structures, and effects described in the embodiments above are included in at least one embodiment and are not necessarily limited to only one embodiment. Furthermore, the features, structures, and effects illustrated in each embodiment can be combined with or modified by those of ordinary skill in the art with respect to other embodiments. Therefore, the matters relating to such combinations and modifications should be construed as being included within the scope of the embodiments. Although the embodiments of the present invention have been described with reference to the attached drawings, those skilled in the art will understand that the present invention can be implemented in other specific forms without changing the technical spirit or essential features thereof. Therefore, it should be understood that the embodiments described above are exemplary in all respects and not restrictive.

**Claims**

**1.** A vehicle charging device comprising:

an amplitude detection unit (11) that detects a magnitude of a grid voltage being inputted to the vehicle charging device;
a frequency detection unit (12) that detects a frequency of the grid voltage;
a PLL (Phase Locked Loop) unit (20) that monitors a phase of the grid voltage; and
a gain selection unit (13) that inputs a coefficient calculated using the magnitude and frequency of the grid voltage to the PLL unit (20),
wherein the amplitude detection unit (11) and the frequency detection unit (12) detect a plurality of points at which the state of the grid voltage changes.

2. The vehicle charging device according to claim 1,

wherein the plurality of points at which the state of the grid voltage changes are points at which the grid voltage changes from an increasing direction to a decreasing direction or from a decreasing direction to an increasing direction, and
wherein the amplitude detection unit (11) detects the amplitude of the grid voltage through an average of the voltages of the plurality of points.

3. The vehicle charging device according to claim 1,

wherein the plurality of points at which the state of the grid voltage changes are points at which the grid voltage changes from an increasing direction to a decreasing direction or from a decreasing direction to an increasing direction, and
wherein the frequency detection unit (12) detects the frequency of the grid voltage through an average of the cycles of the plurality of points.

4. The vehicle charging device according to claim 1,
wherein the PLL unit (20) comprises:

a phase detection unit (21) for detecting an error between the phase of the grid voltage and the phase of the voltage outputted from the PLL unit (20);
an LPF (Low Pass Filter) unit (22) for removing noise from a signal output from the phase detection unit (21); and
a VCO (Voltage Controlled Oscillator) unit (25) for adjusting the voltage frequency of the signal outputted from the LPF unit (22).

5. The vehicle charging device according to claim 4,
wherein the gain selection unit (13) inputs the coefficient to the LPF unit (22) and the VCO unit (25).

6. The vehicle charging device according to claim 5,

wherein the LPF unit (22) comprises a notch filter (23) and an integrator (24), and
wherein the gain selection unit (13) inputs the coefficient to the notch filter (23) and the integrator (24).

7. The vehicle charging device according to claim 1, comprising:
a control unit (14) for setting a plurality of normal operating ranges for the magnitude or frequency of the grid voltage and determining whether each of the magnitude or frequency of the grid voltage is within a normal operating range.

8. The vehicle charging device according to claim 7,
wherein the normal operating range of the magnitude of the grid voltage comprises a plurality of first ranges not being overlapped with one another, and the normal operating range of the frequency of the grid voltage comprises a plurality of second ranges not being overlapped with one another.

9. The vehicle charging device according to claim 8,
wherein the amplitude detection unit (11) detects the maximum and minimum values of the magnitude of the grid voltage during a preset time.

10. The vehicle charging device according to claim 9,
wherein the frequency detection unit (12) detects the maximum and minimum values of the frequency of the grid voltage during the preset time.

**11.** The vehicle charging device according to claim 10,
wherein the control unit (14) determines which range of the plurality of first ranges the magnitude of the grid voltage falls into and which range of the plurality of second ranges the frequency of the grid voltage falls into.

**12.** The vehicle charging device according to claim 11,
wherein the control unit (14) performs vehicle charging when the magnitude of the grid voltage corresponds to at least one among the plurality of first ranges and when the frequency of the grid voltage corresponds to at least one among the plurality of second ranges.

**13.** The vehicle charging device according to claim 11,
wherein the control unit (14) identifies which range among the plurality of first ranges the magnitude of the grid voltage falls into and selects a voltage level for overvoltage protection (OVP) or a voltage level for undervoltage protection (UVP).

FIG. 1

FIG. 2

FIG. 3

| | | | | | | | | | | | | | units |
|---|---|---|---|---|---|---|---|---|---|---|---|---|---|
| fg | 50 | 60 | 50 | 60 | 50 | 60 | 50 | 60 | 50 | 60 | 50 | 60 | [Hz] |
| Wg | 314.1593 | 376.9911 | 314.1593 | 376.9911 | 314.1593 | 376.9911 | 314.1593 | 376.9911 | 314.1593 | 376.9911 | 314.1593 | 376.9911 | [Rad/sec] |
| Vrms | 100 | 100 | 120 | 120 | 220 | 220 | 240 | 240 | 277 | 277 | 1 | 1 | [Vrms] |
| Vpeak | 141.4214 | 141.4214 | 169.7056 | 169.7056 | 311.127 | 311.127 | 339.4113 | 339.4113 | 391.7372 | 391.7372 | 1.414214 | 1.414214 | [V] |
| Wn | 31.41593 | 37.69911 | 31.41593 | 37.69911 | 31.41593 | 37.69911 | 31.41593 | 37.69911 | 31.41593 | 37.69911 | 31.41593 | 37.69911 | [Rad/sec] |
| jeta | 0.707 | 0.707 | 0.707 | 0.707 | 0.707 | 0.707 | 0.707 | 0.707 | 0.707 | 0.707 | 0.707 | 0.707 | |
| Kp | 0.628224 | 0.753868 | 0.52352 | 0.628224 | 0.285556 | 0.342667 | 0.26176 | 0.314112 | 0.226796 | 0.272155 | 62.82236 | 75.38684 | |
| KI | 13.95773 | 20.09913 | 11.63144 | 16.74927 | 6.344422 | 9.135968 | 5.81572 | 8.374637 | 5.038891 | 7.256003 | 1395.773 | 2009.913 | |
| T_constant | 0.045023 | 0.037519 | 0.045023 | 0.037519 | 0.045023 | 0.037519 | 0.045023 | 0.037519 | 0.045023 | 0.037519 | 0.045023 | 0.037519 | |
| Tsamp | 0.0001 | 0.0001 | 0.0001 | 0.0001 | 0.0001 | 0.0001 | 0.0001 | 0.0001 | 0.0001 | 0.0001 | 0.0001 | 0.0001 | [s] |
| B0 | 0.629619 | 0.755878 | 0.524683 | 0.629899 | 0.286191 | 0.343581 | 0.262341 | 0.314949 | 0.227299 | 0.27288 | 62.96194 | 75.58783 | backward |
| B1 | -0.62822 | -0.75387 | -0.52352 | -0.62822 | -0.28556 | -0.34267 | -0.26176 | -0.31411 | -0.2268 | -0.27215 | -62.8224 | -75.3868 | backward |
| B0 | 0.628922 | 0.754873 | 0.524101 | 0.629061 | 0.285873 | 0.343124 | 0.262051 | 0.314531 | 0.227047 | 0.272517 | 62.89215 | 75.48733 | tustin |
| B1 | -0.62753 | -0.75286 | -0.52294 | -0.62739 | -0.28524 | -0.34221 | -0.26147 | -0.31369 | -0.22654 | -0.27179 | -62.7526 | -75.2863 | tustin |

FIG. 4

FIG. 5

1) Phase disturbance

2) Frequency change

3) Amplitude change
(Voltage swell)

FIG. 6

1) Phase disturbance

2) Frequency change

FIG. 7

EP 4 711 182 A1

18

FIG. 8

3) Amplitude change
(Voltage swell)

FIG. 9

FIG. 10

$$V = V_{grid}\sin(\theta_g)$$

FIG. 11

```
            ┌──────────────┐
            │    START     │────────────────┐
            └──────┬───────┘                │
                   │                        │
                   ▼         S11            │
              ╱──────────╲                  │
             ╱ Grid Voltage ╲───────────┐   │
             ╲   input      ╱           │   │
              ╲──────────╱              │   │
                   │         S12        │   │
                   ▼                    │   │
              ╱──────────╲              │   │
             ╱ Charging CMD ╲───────────┘   │
             ╲   receive    ╱               │
              ╲──────────╱                  │
                   │                        │
      S13          ▼                        │
       ┌──────────────────────┐            │
       │   Direction Flag      │            │
       │ Generation and Check  │            │
       │  Counter increase     │            │
       └──────────┬───────────┘            │
      S14         ▼                        │
       ┌──────────────────────┐            │
       │  Save Peak voltage    │            │
       │ At edge of Direction  │            │
       │      Flag             │            │
       └──────────┬───────────┘            │
      S15         ▼                        │
              ╱──────────╲                  │
             ╱ Collection of ╲──────────────┘
             ╲ 4 Peak Voltages╱
              ╲──────────╱
                   │                   S16
                   ▼
       ┌──────────────────────┐
       │  Average of 4 voltage │
       │      peaks            │
       └──────────┬───────────┘
                   │               S17
                   ▼
       ┌──────────────────────┐
       │ Calculation of Counter│
       │      value            │
       └──────────┬───────────┘
                   │               S18
                   ▼
       ┌──────────────────────┐
       │ Determination of Grid │
       │  Voltage, Frequency   │
       └──────────┬───────────┘
                   │               S19
   ┌──────┐        ▼
   │ END  │◄──┌──────────────────────┐
   └──────┘   │ Selection OVP, UVP,   │
              │  OFP, UFP Level       │
              └──────────────────────┘
```

FIG. 12

FIG. 13

Europäisches
Patentamt

European
Patent Office

Office européen
des brevets

# EUROPEAN SEARCH REPORT

Application Number

EP 25 20 1652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ACHLERKAR PANKAJ D ET AL: "Recursive Least Squares-Based Adaptive Parameter Estimation Scheme for Signal Transformation and Grid Synchronization", IEEE JOURNAL OF EMERGING AND SELECTED TOPICS IN POWER ELECTRONICS, IEEE, PISCATAWAY, NJ, USA, vol. 9, no. 2, 30 January 2020 (2020-01-30), pages 2427-2439, XP011843742, ISSN: 2168-6777, DOI: 10.1109/JESTPE.2020.2970445 [retrieved on 2021-03-12] * page 1 - page 6; figures 1,4,5,8 * ----- | 1-5 | INV. B60L3/04 B60L3/12 B60L53/14 B60L53/20 B60L53/62 H02J7/02 G01R23/00 H02H11/00 H02M1/32 |
| X | SALEH BASSEM ET AL: "A comparative study of different PLL techniques for synchronization of grid-connected converters under unbalanced and distorted grid conditions", 2023 25TH EUROPEAN CONFERENCE ON POWER ELECTRONICS AND APPLICATIONS (EPE'23 ECCE EUROPE), EPE ASSOCIATION, 4 September 2023 (2023-09-04), XP034437538, DOI: 10.23919/EPE23ECCEEUROPE58414.2023.10264598 [retrieved on 2023-10-02] * page 1 - page 4; figures 2,7 * ----- | 1-13 | TECHNICAL FIELDS SEARCHED (IPC) B60L H02J G01R H02H H02M |
| X | US 2024/253490 A1 (BERGER ARI [CA] ET AL) 1 August 2024 (2024-08-01) * paragraph [0031] - paragraph [0052]; figures 1,3a * ----- | 1-4,7-13 | |

The present search report has been drawn up for all claims

| Place of search | Date of completion of the search | Examiner |
|---|---|---|
| The Hague | 16 December 2025 | Cuk, Vladimir |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 20 1652

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2025

| Patent document cited in search report | Publication date | Patent family member(s) | | Publication date |
|---|---|---|---|---|
| US 2024253490 A1 | 01-08-2024 | CA | 3219937 A1 | 01-12-2022 |
| | | CN | 117716597 A | 15-03-2024 |
| | | EP | 4348801 A1 | 10-04-2024 |
| | | US | 2024253490 A1 | 01-08-2024 |
| | | WO | 2022246573 A1 | 01-12-2022 |

EPO FORM P0459

For more details about this annex : see Official Journal of the European Patent Office, No. 12/82